(19) Europäisches Patentamt
European Patent Office
Office européen des brevets

(11) Publication number: 0 181 113
A2

(12) # EUROPEAN PATENT APPLICATION

(21) Application number: 85307589.3

(22) Date of filing: 21.10.85

(51) Int. Cl.⁴: H 01 L 21/205
H 01 L 31/02, G 03 G 5/04

(30) Priority: 05.11.84 US 668435

(43) Date of publication of application:
14.05.86 Bulletin 86/20

(84) Designated Contracting States:
CH DE FR GB IT LI NL

(71) Applicant: SOVONICS SOLAR SYSTEMS
6180 Cochran Road
Solon Ohio 44139(US)

(72) Inventor: Yang, Chi Chung
1676 Lakewood Drive
Troy Michigan 48084(US)

(72) Inventor: Mohr, Ralph
16291 Fairmount
Detroit Michigan 48205(US)

(72) Inventor: Hudgens, Stephen
2 Alexandria Towne
Southfield Michigan 48075(US)

(72) Inventor: Johncock, Annette
244 South Pontiac Trail
Walled Lake Michigan 48088(US)

(72) Inventor: Nath, Prem
245 Prospect
Rochester Michigan 48065(US)

(74) Representative: Jackson, Peter Arthur et al,
GILL JENNINGS & EVERY 53-64 Chancery Lane
London WC2A 1HN(GB)

(54) **Improved boron doped semiconductor materials and method for producing.**

(57) An improved p-type semiconductor alloy film, improved photovoltaic and photoresponsive devices incorporating such films and radio frequency and microwave glow discharge methods for fabricating same. The improved semiconductor alloy films preferably include at least silicon deposited by the glow discharge of a compound containing at least silicon and a boron species that remains substantially mono-atomic as it is incorporated into the silicon matrix. The p-type film is particularly stable, is characterized by a non-narrowed band gap, reduced bulk stress, improved morphology, growth and adhesion and reduced peeling and cracking. The substantially intrinsic film is characterized by substantially reduced Staebler-Wronski degradation. The method includes the novel step of introducing a boron species that does not form higher order boron hydrides or other boron polymers or oligomers in a glow discharge plasma.

Croydon Printing Company Ltd.

SOVONICS SOLAR SYSTEMS Ref: 50/2795/02

# IMPROVED BORON DOPED SEMICONDUCTOR MATERIALS AND METHOD FOR PRODUCING

Glow discharge deposited hydrogenated and fluorinated amorphous semiconductor alloys films have gained commercial acceptance in low cost and efficient photovoltaic, semiconductor and electronic devices. .The term "amorphous", as used here, includes all materials or alloys that have no long range order, although they may have short or intermediate range order or even contain, at times, crystalline inclusions. P-type amorphous silicon alloys have been of poorer quality than n-type or intrinsic type alloys because p-type alloys contain a larger density of electronic states in the "tail" of the valence band than exist in the "tail" of the conduction band. Consequently, it has not been possible to shift the Fermi level closer than 0.3 electron-volts to the valence band by p-doping. By contrast, the Fermi level can be shifted all the way to the conduction band in n-type doping. Up to the date of the present invention, diborane was the precursor process gas used in glow discharge deposition processes to dope amorphous semiconductor alloys p-type.

The reasons for the poor performance of semiconductor alloy layers incorporating boron from a diborane precursor gas are not fully understood. It is known that diborane, under the influence of the electromagnetic field in a glow discharge deposition process, tends to produce higher boron oligomers and polymers, referred to here as "non-mono-atomic boron species". These higher order boron hydrides are very difficult to decompose in the glow discharge process and tend to be incorporated into the semiconductor alloy material in the form of chains of boron. Boron chains that are incorporated in an amorphous semiconductor film tend to alloy with, rather than substitutionally dope, the semiconductor. The alloying is evidenced by band gap narrowing observed in these materials. Moreover, thin film

semiconductor p-type alloys produced by glow-discharge deposition from silane and diborane precursor gases exhibit a high density of defect states, marked degradation when used as the photoactive layer of a photovoltaic device and high mechanical stress.

Various researchers have experimented with boron-containing species other than diborane, such as boron trifluoride ($BF_3$), as a boron precursor gas.

Mahan et al., in "$BF_3$-Doped Amorphous Silicon Thin Films, 12 J. of Electronic Materials" (No. 6, 1983), 1033-51, described radio frequency glow discharge deposition of amorphous silicon doped with boron from boron trifluoride. The authors concluded that the maximum amount of boron that could be incorporated in the deposited films was 1.8 atomic percent (from 3.5 percent boron trifluoride in silane), much lower than the incorporation from a diborane source. The films had an activation energy of .34 electron volts and a band gap substantially similar to that of undoped amorphous silicon alloys.

The authors recognized the advantages of using a boron trifluoride doping source to maintain a constant band gap in the doped semiconductor alloy material. They suggested its use in the p-layer of a p-i-n type amorphous silicon photovoltaic device, but stated that because dopant incorporation decreases steadily as boron trifluoride concentration is increased, the necessary levels of doping could not be achieved from boron trifluoride. Therefore, while recognizing the need for a heavily p-doped silicon alloy material having a relatively wide band gap, their experiments and comments indicate that a boron trifluoride precursor gas cannot produce sufficient concentrations of boron in the alloy.

Devaud, et al. in "$BF_3$-Doped Amorphous Silicon Thin Films", ________________ (            ) pp. 384-390, disclosed the use of boron trifluoride as a dopant source for glow discharge deposited amorphous silicon alloy films. They were unable to incorporate sufficient amounts of boron into their films to fabricate a highly doped p-layer of amorphous semiconductor alloy material.

U.S. Patent No. 4,409,424 to Devaud is similar to her paper, but discloses the use of boron trifluoride as a doping source only for compensation doping of the intrinsic layer in a p-i-n type photovoltaic cell. Diborane, rather than boron trifluoride was used as the precursor doping gas for the p-doped layer of a p-i-n cell, presumably to obtain a higher dopant concentration than obtainable with boron trifluoride. The Devaud references disclose the use of deposition gas mixtures containing up to 10 percent boron trifluoride, but those atmospheres are inadequate for the deposition of a p-doped silicon alloy film according to the present invention.

R. V. Kruzelecky, et al. at the University of Toronto (Canada) determined that boron trifluoride-doped amorphous silicon alloy films exhibit substrate dependent problems of adhesion that they attributed to the use of boron trifluoride. The most heavily doped boron containing film obtained from glow discharge in silane and boron trifluoride had an activation energy of 0.31 electron volts, substantially the same as the silicon alloy films described in the Devaud references. Analysis of the films revealed that only approximately 0.2 to 0.5 atomic percent of boron and a similar amount of fluorine were incorporated in Kruzelecky's films and no significant narrowing of the band gap occurred.

In one aspect, the invention involves a method for the continuous production of an electronic device by depositing a plurality of superposed layers of semiconductor alloy material onto a web of substrate material as the web passing through at least one vacuum deposition chamber maintained at subatmospheric pressure. The method includes exposing the web to atmospheric pressure between deposition of different alloy layers. The first deposited layer, preferably is a p-doped, and the web of substrate material may be stored prior to the deposition of subsequent layers of semiconductor alloy material. The p-doped alloy layer further includes a halogen or a pseudo-halogen. The boron species is selected from the group consisting essentially of boron trifluoride, silicon trichloride-boron trifluoride, substituted boron

halides, boron pseudo-halides and mixtures thereof. The halogen or pseudo-halogen is preferably fluorine, the semiconductor is preferably silicon or a silicon alloy.

In another aspect of the invention, an electronic device includes at least one pair of adjacent p-doped and n-doped thin film semiconductor alloys forming a tunnel junction. At least one of the p-doped layers in the improved tunnel junction includes boron and a halogen or pseudo-halogen, preferably fluorine.

In yet another aspect of the invention, a method of fabricating an improved semiconductor alloy material that includes at least 1.9 percent boron and a halogen or a pseudo-halogen is disclosed. Preferably boron trifluoride is the gaseous source of the boron, and fluorine is the halogen or pseudo-halogen, silicon or a silicon alloy is the semiconductor material. A photoresponsive device may be fabricated by forming a p-doped layer from the improved semiconductor material, forming an n-doped semiconductor alloy layer, forming a substantially intrinsic semiconductor layer between the p-doped and n-doped layers, and introducing trace levels of boron from the precursor boron species gas into the host matrix of the semiconductor material of the intrinsic layer. In this manner, the boron-containing intrinsic layer substantially reduces Staebler-Wronski degradation.

In one aspect of the invention, an electrophotographic photoreceptor including an electrically conductive substrate and a photoconductive member formed of a semiconductor alloy material, including at least trace amounts of boron and a halogen or pseudo-halogen in the semiconductor host matrix thereof, are in electrical communication. The photoconductive member may be formed of an amorphous silicon:hydrogen:fluorine alloy including sufficient amounts of boron to achieve an activation energy in the range of 0.8 to 1.2 electron-Volts. A blocking layer formed of a semiconductor alloy material having a conductivity type chosen to inhibit the injection of charge carriers from the substrate into the photoconductive member, may

be interposed between the photoconductive member and the substrate. Preferably, the blocking layer is formed of an amorphous silicon:hydrogen:fluorine alloy and includes a greater amount of boron than does the photoconductive member. An adhesion-promoting layer is preferably interposed between the substrate and the blocking layer, and an insulative layer is preferably disposed on top of the photoconductive layer.

In another aspect of the invention, an improved electrophotographic photoreceptor of the type including an electrically conductive substrate and a photoconductive member in electrical communication, is formed of a plurality of superposed layers of semiconductor alloy material, the superposed layers differing in the concentration of at least one element thereof. In this manner, the bulk stress within the photoconductive member is relieved to improve the charge storage capability of the photoreceptor. Preferably, each of the superposed layers of semiconductor material includes at least trace amounts of boron and a halogen or a pseudo-halogen in its host matrix. Preferably, the photoconductive member is approximately 15 to 30 microns thick and displays columnar growth morphology. The photoreceptor includes a blocking semiconductor alloy layer between the photoconductive member and the substrate, the semiconductor layer being approximately 200 to 600 nanometers thick and includes a greater amount of boron than does the photoconductive member. There is also an adhesion-promoting layer of approximately 50 to 200 nanometers interposed between the blocking layer and the substrate, and an electrically insulating layer less than 600 nanometers thick disposed on the photoconductive member.

In still another aspect of the invention, a glow discharge deposition method is used to produce an improved electrophotographic photoreceptor of the type including a photoconductive member. The method includes use of a source of mono-atomic boron and a halogen or pseudo-halogen in the glow discharge gas mixture. Preferably, the

precursor gas mixture includes silicon in combination with fluorine and hydrogen. A doped semiconductor layer is preferably disposed between the substrate and the photoconductive member by glow discharge deposition from gaseous mixture including silane, silicon tetrafluoride, hydrogen and boron trifluoride. An adhesion-promoting layer may be deposited on the substrate member, chosen from the group consisting essentially of silicon nitride, silicon carbide, silicon oxide and combinations thereof. Finally, a layer of electrically insulating material may be deposited on top of the photoconductive member.

Figure 1 is a fragmentary, cross-sectional view of a tandem photovoltaic device including a plurality of p-i-n type cells, each layer of the cells formed from a semiconductor material.

Figure 2 is a schematic, cross-sectional view of a multiple chamber glow discharge deposition apparatus for continuous production of photovoltaic devices.

Figure 3A is a voltage versus current characteristic typical of the performance of a tandem p-i-n photovoltaic cell that incorporates diborane doped layers of semiconductor alloy material.

Figure 3B is a voltage versus current characteristic typical of the performance of a tandem p-i-n photovoltaic cell that incorporates boron trifluoride doped layers of semiconductor alloy material.

Figure 4 is a graphic representation of normalized photovoltaic cell efficiency versus time illustrating the improved performance of cells according to the invention.

Figure 5 is a schematic, cross-sectional view of a multiple chamber glow discharge deposition apparatus, similar to the apparatus of Figure 2, but illustrating one aspect of the invention.

Figure 6 is a schematic, cross-sectional view of a single chamber glow discharge deposition apparatus.

Figure 7 is a cross-sectional view of an electrophotographic drum fabricated in accordance with the invention.

Figure 1 shows a tandem p-i-n type photovoltaic device 10 composed of p-i-n type cells 12a, 12b and 12c. Adjacent cell 12a is a substrate 11 that may be transparent or formed from a metallic material such as stainless steel, aluminum, tantalum, molybdenum, chrome, or metallic particles embedded within an insulator. Although certain applications may require a thin oxide layer and/or a series of base contacts be disposed on the substrate prior to application of the amorphous material, the term "substrate" means not only a flexible film, but also any elements added to it by preliminary processing. Substrates may be formed of glass or a glass-like material on which an electrically conductive material is applied as an electrode.

Each of the cells 12a, 12b and 12c is preferably fabricated of an amorphous semiconductor body containing at least a silicon alloy. Each of the semiconductor bodies includes an n-type conductivity semiconductor layer 20a, 20b and 20c; an intrinsic semiconductor layer 18a, 18b and 18c; and a p-type conductivity semiconductor layer 16a, 16b and 16c. The intrinsic layers may include traces of n-type or p-type dopant material without forfeiting their characteristic neutrality. Cell 12b is an intermediate cell and, as indicated in Figure 1, additional intermediate cells may be stacked on the illustrated cells. The methods and materials of this invention may also be utilized to produce single or multiple n-i-p cells, p-n cells, Schottky barrier cells, as well as other semiconductor or devices such as diodes, memory arrays, photoconductive devices and the like. A TCO (transparent conductive oxide) layer 22 is added on top of layer 20c and an electrode grid 24 may be deposited on TCO layer 22 to increase the current collection efficiency.

In Figure 2 an apparatus 26 for depositing amorphous semiconductor layers of p-i-n configuration on a surface of a continuous web of substrate material 11 is shown. Apparatus 26 includes at least one triad of deposition chambers. Each triad of deposition chambers comprises: a first deposition chamber 28 in which a p-type conductivity

semiconductor layer is deposited on substrate 11 as the substrate passes through; a second deposition chamber 30 in which an intrinsic semiconductor layer is deposited on the p-type layer; and a third deposition chamber 32 in which a n-type semiconductor layer is deposited on the intrinsic layer. Although only one triad of deposition chambers has been illustrated, additional triads or additional individual chambers may be added to the apparatus to produce photovoltaic cells having any number of p-i-n type semiconductor layers.

Each of deposition chambers 28, 30 and 32 includes: a cathode 34; a shield 35 disposed about the cathode; a process gas supply conduit 36; a radio frequency generator or other electromagnetic power source 38; a process gas and plasma evacuation conduit 41; a plurality of transversely extending magnetic elements 50; a plurality of radiant heating elements 40; and a gas gate 42 operatively interconnecting chamber 30 to chambers 28 and 32. Additionally, an inert sweep gas conduit 37 is disposed on opposed sides of chamber 30 for directing an inert gas toward chambers 28 and 32.

Electromagnetic power generator 38 operates in conjunction with cathodes 34, radiant heaters 40 and grounded substrate 11 to form a plasma disassociating the reaction gases entering the deposition chambers into deposition species. These species are then deposited on substrate 11. Substrate 11 is maintained substantially flat by magnetic elements 50. Deposition apparatus 26 requires the use of costly and intricately designed gas gates 42 to maintain a subatmospheric pressure and to avoid exposing substrate 11 to the potentially contaminating atmosphere between the deposition of the various layers.

The known methods of making p-doped amorphous semiconductor alloy films have predominantly used diborane as a dopant precursor gas. Diborane polymerizes under glow discharge deposition conditions. Mono-atomic boron-halogens and pseudo-halogens remain substantially mono-atomic in a glow discharge plasma. "Mono-atomic boron species" means a boron species that includes a single boron atom and is stable in

glow discharge deposition process conditions. Glow discharge deposition conditions generally include temperatures of from about 200°C to about 300°C, and preferably about 225°C, and pressures of from about 65 to about 130 pa. and preferably about 85 to about 120 pa.

"Halogens" and "halogens and pseudo-halogens" refer to halogen-containing materials and other compounds that can be substituted for and react as halogens in a glow discharge deposition reaction. As an example, boron trifluoride is a halogen-containing compound. CN-, CNO- and SCN- moieties are examples of pseudo-halogens that can be substituted for the fluorine atom in boron trifluoride.

Boron species that remain mono-atomically stable under the glow discharge deposition conditions have been found to produce p-type amorphous semiconductor alloys having band gap energies substantially equivalent to those of comparable intrinsic semiconductor alloy materials without detrimentally lowering the electrical conductivity of the alloys thus formed. Incorporation of a mono-atomic boron species that includes a halogen or pseudo-halogen in amorphous semiconductor alloys to achieve p-doping also produces alloys having superior morphology, exhibiting better growth and reduced stress without substantially narrowing the band gap. When the mono-atomic doping source is boron trifluoride, rather than a polyatomic source such as diborane, higher boron concentrations may be used in the gaseous glow discharge deposition process without forming undesirable higher order boron species. Preferably, the ratio of silane to mono-atomic boron species in the glow discharge gas mixture ranges from about 10:1 mole percent to about 1:1 mole percent.

Boron-containing materials that are mono-atomically stable under glow discharge deposition conditions include boron trifluoride, silicon trichloride-boron trifluoride, substituted boron halides, and boron-pseudo-halides. These materials do not readily combine to form polymeric boron materials under glow discharge conditions. For example, in the case of boron trifluoride, pairs of electrons from fluorine can back-conjugate to form such structures such as:

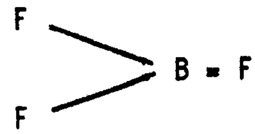

This back-conjugation stablizes the boron atom by filling a vacant orbital. The stabilized species is incorporated into the deposition semiconductor alloy host matrix in a substantially tetrahedral form that is effective in doping the host matrix. Borane, $BH_3$, and diborane, $B_2H_6$, cannot be so stabilized because hydrogen does not have the extra electron pairs provided by fluorine in boron trifluoride that are responsible for the back-conjugation.

The improved incorporation of boron into the semiconductor alloy host matrix leads to increased substitutional doping efficiencies and decreased levels of undesirable states in the band gap of the doped alloy materials. These improvements are important in the fabrication of highly doped semiconductor alloys layers such as the p-doped layer of a p-i-n photovoltaic device because high doping concentrations can be achieved without significantly narrowing the band gap of the alloy or introducing a significant number of defect states. The improved doping ability is also useful in lightly doped layers of seimconductor alloy material, such as the intrinsic semiconductor alloy layers of p-i-n photovoltaic devices that incorporate trace levels of boron. In such devices it has been found that Staebler-Wronski degradation of the intrinsic layer is significantly curtailed, and in some instances eliminated, by the substitutional incorporation of even trace amounts of boron. The improved substitutional incorporation of the dopant atoms into the host matrix and the decreased density of defect states in the band gap of the doped semiconductor alloy layer is believed to result in the establishment of stronger electric field within the device, providing increased stability and photoconversion efficiencies.

In tandem amorphous semiconductor alloy photovoltaic cells, such as the one depicted in Figure 1, it has been found that in depositing the second p-doped layer on the first n-doped layer, the p-doped layer appears to grow in a stressed manner that gives the complete structure a cloudy, hazy appearance. This cloudiness and haziness is accompanied by a reduced overall efficiency of the photovoltaic cell since the haze interferes with the transmission of solar radiation. It has been found, however, that the second p-doped layer of a tandem photovoltaic cell has remarkable clarity when deposited with a mono-atomic boron species as the dopant.

Moreover, the tunnel junctions created between the adjacent p and n-doped layers of tandem p-i-n cells appear to have improved properties when the p-type material is doped with a mono-atomic boron species. The voltage-current characteristics of tandem p-i-n cells fabricated with diborane as the dopant source in the p-type layers and with boron trifluoride as the dopant source in the p-type layers are shown in Figures 3A and 3B, respectively. The kink 13 present in the first quadrant of Figure 3A does not appear in Figure 3B. The improved characteristic, attributable to the boron trifluoride doping source, results in more efficient conversion of incident light to electricity.

Example 1

An amorphous silicon photovoltaic cell, generally similar to cell 10 depicted of Figure 1 was produced. A stainless steel substrate was disposed in the deposition chamber of a capacitively coupled glow discharge apparatus operated at 13.56 MHz and maintained at 225°C. The first p-type layer was deposited from an atmosphere formed from a flow of 0.3 standard cubic centimeters per minute (i.e., sccm) silane, 0.03 sccm of boron trifluoride diluted with a sufficient amount of argon to maintain a pressure of about 95 pa in the chamber. The cathode was energized with 2 watts of power for 3 minutes. A 30 nanometer thick layer of p-doped silicon alloy layer was deposited.

The chamber was flushed and the first intrinsic layer was deposited from an atmosphere formed from a flow of 1.0 sccm of silane, 8.88 sccm of hydrogen, 0.12 sccm of germane, 10.0 sccm of argon at a total pressure of about 100 pa. A power of 3 watts was applied for three minutes and a 330 nanometer thick substantially intrinsic silicon alloy layer was deposited.

After flushing the chamber with argon, the first n-type layer was deposited from a flow of 0.5 sccm of silane, 1.5 sccm of silicon tetrafluoride, 6.0 sccm of hydrogen and 2.0 sccm of phosphine maintained at a pressure of 120 pa. A power of 4 watts was maintained for 30 seconds, producing an 8 nanometer thick layer of n-type silicon alloy.

After flushing the chamber with argon, a second p-type silicon alloy layer was deposited from an atmosphere of 0.2 sccm of silane, 0.08 sccm of boron trifluoride and 39.72 sccm of argon maintained at a pressure of about 115 pa. Power of three watts was applied for 40 seconds to deposit an 8 nanometer thick p-type silicon alloy layer.

After another argon flush, a second intrinsic silicon alloy layer was deposited from an atmosphere consisting of 3.0 sccm of silane and 7.0 sccm of hydrogen maintained at a pressure of about 70 pa. A power of two watts was maintained for 10 minutes to deposit a 100 nanometer thick intrinsic silicon alloy layer.

The deposition system was again flushed with argon and a second n-type silicon alloy layer deposited from an atmosphere of 0.5 sccm of silane, 1.5 sccm of silicon tetrafluoride, 7.0 sccm of hydrogen and 1.0 sccm of phosphine maintained at a pressure of 105 pa. A power of 4 watts applied for 25 seconds deposited an 8 nanometer thick n-type silicon alloy layer.

An electrode of indium tin oxide was deposited on the second n-type layer and a current collecting grid was deposited on the oxide by evaporation. Under direct sunlight, taking account of the atmosphere (i.e., AM-1 conditions), the open circuit voltage, $V_{oc}$, was 1.553 volts, the short circuit current density, $J_{sc}$, was 8.377 milliamperes

per square centimeter, the overall surface area of the cell was .25$cm^2$, the fill factor was .666, and the overall photoconversion efficiency was 8.667 percent.

A portion of the photovoltaic cell thus produced was analyzed. The first p-layer contained 1.5 percent boron and 0.6 percent fluorine. The second p-type layer contained 3.4 percent boron and 1.9 percent fluorine.

Example 2

A number of very large-area p-i-n type photovoltaic cells were prepared by a glow discharge deposition process similar to that described in Example 1. These cells were each about 0.1 $m^2$ in area and included a p-doped semiconductor alloy layer of approximately 50 nanometers thickness, a substantially intrinsic semiconductor alloy layer of approximately 600 nanometers thickness and an n-doped semiconductor alloy layer of approximately 15 nanometers thickness deposited upon a stainless steel substrate. The completed cells were each provided with a 60 nanometer thick indium tin oxide electrode and a screen printed, current collecting grid pattern deposited on the electrode. The deposition parameters and precursor reaction gas mixtures were similar to those parameters and mixtures employed in Example 1.

Three such photovoltaic cells were prepared using different precursor reaction gas mixtures. Single p-i-n cells of 665 nanometer total thickness, such as those prepared in this example, will, under normal operating conditions, exhibit a high degree of photodegradation (Staebler-Wronski degradation) because of the relatively thick intrinsic layer (approximately 400 nanometer thick) and the relatively low electric field developed across it by the doped semiconductor alloy layers.

Sample 1 was deposited using diborane as the doping precursor gas for both the p-doped semiconductor alloy layer and the intrinsic semiconductor alloy layer. The precursor gas mixture for the deposition of the p-doped semiconductor alloy layer comprised diborane and silane gases in a ratio of approximately 1 part diborane to 10 parts silane. The intrinsic semiconductor alloy layer was provided with relatively low levels (a few parts per million) of a diborane precursor dopant by relying upon desorption of the residual gaseous boron species absorbed by the walls of the deposition chamber during the deposition of the p-doped semiconductor alloy layer.

Sample 2 was fabricated by a process generally similar to the process for fabricating Sample 1 except that boron trifluoride was used as the dopant precursor gas for both the p-doped and the substantially intrinsic semiconductor alloy layer. The ratio of silane to boron trifluoride employed in depositing the p-doped semiconductor alloy layer was approximately ten to one. As was the case for Sample 1, boron trifluoride doping of the intrinsic semiconductor alloy layer in Sample 2 was accomplished by relying upon the desorption of residual boron species absorbed by the walls of the deposition chamber during deposition of the first p-type layer.

Sample 3 was fabricated by a process that included a p-type semiconductor alloy layer doped from a boron trifluoride precursor and a substantially intrinsic semiconductor alloy layer devoid of boron and boron species. The deposition parameters for p-type layer doped from the boron trifluoride source were generally similar to the deposition parameters of the corresponding layer for the Sample 2 photovoltaic cell in that the ratio of silane to boron trifluoride in the precursor gaseous atmosphere was also about 10 to 1. In Sample 3, however, the residual boron trifluoride absorbed by the walls of the deposition chamber during the deposition of the p-doped semiconductor alloy layer was removed from the chamber by a thorough cleansing prior to the deposition of the intrinsic semiconductor alloy layer.

The electrical characteristics of the photovoltaic cells, so prepared, were measured, and the cells were then exposed to AM-1 simulated solar radiation. The photovoltaic characteristics of the three cells were periodically measured and the accumulated data is plotted in Figure 4.

Normalized efficiencies of the three photovoltaic cells (Samples 1-3) are plotted on the ordinate and the length of exposure of the cells to AM-1 illumination, in hours, is plotted on the abscissa. Sample 2, doped from the boron trifluoride source, exhibited the lowest degree of photodegradation, retaining over 90 percent of its initial operating efficiency after 200 hours.

In the fabrication of semiconductor devices, such as p-i-n type photovoltaic devices, it has been found that if a surface of the semiconductor alloy layers, especially the p-doped semiconductor layer, is exposed to the atmosphere prior to the deposition of succeeding semiconductor layers, device performance is degraded. The degradation is attributed to the introduction of surface states detrimental to the formation of a good interface between that layer and the succeeding semiconductor layer.

To avoid degradation of surfaces, semiconductor layers have been successively deposited in a single vacuum envelope, as previously described with respect to Figure 2. In a single deposition chamber (i.e., a batch process) apparatus, it was required that the deposition chamber be completely purged and flushed with an inert gas, without admitting the atmosphere, between the deposition of each of the successive semiconductor layers. The problem of surface degradation is alleviated through the use of mono-atomic boron halogen and boron pseudo-halogen compounds, simplifying deposition processes and apparatus. Apparently the boron in materials doped from a boron trifluoride source induces the formation of stronger surface bonds so that potential contaminants in the atmosphere do not affect exposed surfaces.

In Figure 5, a schematic representation of a multiple chamber glow discharge apparatus 60 bears some structural similarities to the glow discharge deposition apparatus 26 of Figure 2. Elements similar in structure and function will be referred to in Figure 5 by the same reference numerals used in Figure 2. Apparatus 60 includes three deposition chambers 28, 30 and 32. A web of substrate material 11 is continuously fed through chambers 28, 30 and 32 for the successive deposition of semiconductor layers on it. Apparatus 60 lacks the gas gates (42 in Figure 2) interconnecting deposition chambers 28, 30 and 32. Because the semiconductor coated web of substrate material 11 is not degraded by exposure to atmospheric conditions, deposition system 60 need not be confined within a single vacuum envelope. Accordingly, simple vacuum to air seals 62 may be employed to convey the coated web of substrate material 11 into and out of the successive deposition chambers.

A single chamber semiconductor deposition apparatus 64 for continuous operation is shown schematically in Figure 6. A deposition chamber 31 includes a process gas inlet 36 and an exhaust port 41 that cooperate to maintain the desired deposition atmosphere in chamber 31 and a cathode 34 energized by a source of electromagnetic energy, such as a radio frequency power supply 38. Figure 6 also schematically depicts substrate pay-off and take-up reels, 11a and 11b, that cooperate to advance a web of substrate material 11 through deposition chamber 31 continuously. Vacuum-to-atmosphere seals 62, well-known to those skilled in the art and generally similar to seals 62 of Figure 5 admit web 11 into and out of chamber 31.

Apparatus 64 deposits a single semiconductor layer upon web 11. A coated web is then wound about take-up reel 11b. Because of its "inertness" to ambient atmosphere conditions, the coated web may be stored for further processing into semiconductor devices. For example, it may be desirable to prepare a large amount of coated substrate bearing a given type of semiconductor layer. Subsequently, as the need

arises, other semiconductor or metallic layers may be deposited on the coated substrate to manufacture a variety of variously configured semiconductor electronic devices.

As mentioned, apparatus 64 of Figure 6 may be used to deposit a plurality of semiconductor layers on web 11 sequentially. For example, the p-layer of a p-i-n type photovoltaic cell may be deposited on web 11 as it advances through chamber 31, and the coated web may then be stored. At a later time, web 11 is again advanced through the deposition chamber for the deposition of the intrinsic layer. Still later, an n-type layer is deposited on the intrinsic layer. In this manner, a p-i-n photovoltaic cell may be prepared on an elongated web of substrate material without the necessity of employing a plurality of dedicated deposition chambers that are maintained under a continuous vacuum.

A photoreceptor 70 for use in an electrophotographic process in Figure 7, includes a plurality of layers of semiconductor alloy material deposited upon an electrically conductive substrate member 72 that may be formed of a rigid, durable material such as aluminum or stainless steel. Immediately on substrate 72 is an adhesion-promoting layer 74 that functions to provide a tight bond between the substrate 72 and the successively deposited layers. Adhesion-promoting layer 74 is preferably formed from a material such as silicon nitride, silicon oxide or silicon carbide and is typically about 100 nanometers thick. A blocking layer 76, disposed on adhesion-promoting layer 74, is typically formed of a doped semiconductor alloy material having a conductivity type chosen to prevent the injection of charge carriers from substrate 72 into the successively deposited layers of photoreceptor 70. In the preferred embodiment, blocking layer 76 is formed from a silicon:hydrogen:fluorine alloy doped with a sufficient amount of boron to make it a p-type conductivity layer (referred to herein as a "lightly" p-doped layer).

A photoconductive member 78 is disposed immediately on top of blocking layer 76. Photoconductive member 78 accumulates and holds a static electric charge in the dark and conducts away that charge when and where illuminated. In the illustrated embodiment, photoconductive member 78 is preferably approximately 25 microns thick and is formed from an alloy of silicon:hydrogen:fluorine that mono-atomically incorporates the boron halogen or boron pseudo-halogen species of the invention. An insulating layer 80 may be disposed on photoconductive member 78. This insulating layer, which is approximately 600 nanometers or less in thickness and may be formed from an insulating material such as silicon carbide or organic materials, protects photoconductive member 78 from mechanical damage and aids in charge retention by preventing ambient atmospheric ions from discharging a static charge on photoconductive member 78.

Electrophotographic photoreceptor 70 is a relatively thick device, especially in comparison to other semiconductor devices such as the photovoltaic cells already described. Accordingly, problems of internal stress and bulk strain are quite significant in photoreceptors. It is difficult to quantify the amount of bulk stress and strain in a sample of semiconductor material, however, the presence of stress and strain may be inferred from the formation of haze in the layer and a decrease in the charge storing capacity, i.e., saturation voltage, of that layer. Strain in the various semiconductor layers of a photoreceptor can cause those layers to crack, decreasing the charge holding capability of the photoreceptors. Cracks may encourage nucleation of undesirable morphologies that propagate throughout the entire thickness of the photoreceptor. The incorporation of boron halides or pseudo-halides in the various semiconductor alloy layers of an electrophotographic photoreceptor results in a notable and substantial decrease in the bulk stress.

In accordance with another aspect of the invention, photoconductive member 78 may include a plurality of superposed layers of varying composition. This laminar structure provides further stress relief. In one preferred embodiment, photoconductive member 78 is a 25 micron thick layer including two superposed 12.5 micron thick layers that differ slightly only in the total amount of fluorine incorporated in each. Depending upon the total thickness of the semiconductor layer to be deposited, structures comprised of a still greater number of laminated layers can also be advantageously employed to provide further stress relief.

While the semiconductor layers from which electrophotographic photoreceptor 70 of Figure 7 are fabricated may be prepared via a variety of well known thin film semiconductor deposition techniques such as sputtering, evaporation, or radio frequency energized glow discharge deposition, it has been found that microwave energized glow discharge deposition, because of its comparatively high rate of deposition, is especially advantageous for preparing the relatively thick photoreceptor layers.

A photoreceptor, generally similar to that depicted in Figure 7, was prepared as follows in a microwave glow discharge process. A cleaned and polished aluminum substrate was placed in a deposition chamber having a volume of approximately 600 $cm^3$. A deposition atmosphere of silane and nitrogen was provided in the deposition chamber which was maintained at a a pressure of approximately 3 pa. The substrate was heated to 250°C, microwave energy of 120 watts having a frequency of 2.54 GHz was applied and the deposition of the silicon nitride layer began. The silicon nitride was deposited at a rate of approximately 0.2 nanometers per second to form, after 1000 seconds, a 100 nanometer thick silicon nitride film. A new gaseous atmosphere comprising 30 sccm of silane, 3 sccm of silicon tetrafluoride, and .2 sccm of 3.9 percent boron trifluoride in hydrogen was introduced to flow through the chamber, at a chamber pressure of about 3 pa. This resulted

in a ratio of 260 ppm boron trifluoride to silane. The substrate was maintained at a temperature of 250°C and the deposition proceeded at a rate of 10 nanometers per second for 50 seconds. The deposition was then terminated with the deposition of a layer of lightly p-doped silicon alloy material of approximately 500 nanometers thickness.

The photoconductive layer was deposited as a dual layer structure as described above. A deposition atmosphere of 30 sccm of silane, 2 sccm of silicon tetrafluoride and .02 sccm of 3.9 percent boron trifluoride in hydrogen was introduced to flow through the chamber which was maintained at 3 pa. pressure. This represented a ratio of 26 ppm boron trifluoride to silane. The substrate was maintained at a temperature of 225°C, and the deposition occurred at a rate of approximately 15 nanometers per second. After approximately 12.5 microns of a silicon alloy layer was deposited, the flow of silicon tetrafluoride was increased to approximately 4 sccm and the deposition continued until approximately an additional 12.5 microns of a silicon alloy layer was deposited.

Following the deposition of the photoconductive layer, a 600 nanometer thick top protective layer of silicon carbide was deposited by a glow discharge decomposition of an atmosphere of silane and methane.

The electrophotographic photoreceptor thus produced exhibited no visible signs of bulk stress, i.e., no cracking or peeling was noted. It was additionally found in use that the photoreceptor could sustain an electrostatic charge of approximately 400 volts while a similarly configured photoreceptor fabricated using a diborane doping source could sustain a voltage of only 200 volts. These superior qualities that are exhibited by the deposited semiconductor alloy material may be termed "synergistic" when it is realized that the material was deposited by a microwave glow discharge process. The term synergistic is used because applicants have previously believed that glow discharge deposition processes powered by microwave energy rather than frequency energy, normally deposit highly stressed films.

Therefore, it was possible to deposit, by a microwave powered glow discharge process, a semiconductor film of 25 microns thickness that not only adhered to the substrate, but exhibited excellent electrical and mechanical properties. Applicants believe that the explanation lies in the use of boron halogens and pseudo-halogens that remain substantially mono-atomic even in the energetic environment of a high electron temperature microwave powered plasma.

While the foregoing example describes the fabrication of an electrophotographic photoreceptor by a microwave activated process, the invention is not so limited. Superior stress relief in electrophotographic photoreceptors may be achieved in the formation of the semiconductor matrix through the use of the mono-atomically incorporated boron halogen or boron pseudo-halogen species as well as by the use of a laminar structure for forming one or more of the various layers of the electrophotographic photoreceptor.

## CLAIMS

1. A method of depositing an improved p-type amorphous semiconductor alloy including at least boron and a halogen or a pseudo-halogen, said method including establishing a glow discharge in a gaseous mixture including at least one semiconductor precursor gas, a gaseous source of boron combined with one of a halogen and pseudo-halogen, characterized in mono-atomically incorporating at least 1.9 atomic percent of boron into the semiconductor alloy as said alloy is being deposited.

2. The method of claim 1 characterized in that said gaseous source of boron is boron trifluoride.

3. The method of claim 1 characterized in that said one of a halogen and pseudo-halogen is fluorine.

4. The method of claim 1 characterized in that said semiconductor alloy is selected from silicon, germanium and mixtures thereof.

5. The method of claim 1 characterized in that said semiconductor precursor gas is silane.

6. The method of claim 1 characterized in that said gaseous mixture includes argon.

7. An electrophotographic photoreceptor (70) including an electrically conductive substrate (72) and a photoconductive member (78) in electrical communication therewith, characterized in that said photoconductive member (78) is formed of a semiconductor alloy material including at least trace amounts of boron and a halogen or pseudo-halogen mono-atomically incorporated into the semiconductor host matrix, said semiconductor alloy material exhibiting reduced bulk stress.

8. The photoreceptor (70) of claim 7 characterized in that the photoconductive member (78) is at least 10 microns in thickness.

9. The photoreceptor (70) of claim 7 characterized in that the photoconductive member is formed of a semiconductor alloy material including at least one of a silicon alloy, a germanium alloy and a silicon-germanium alloy in the host matrix.

10. The photoreceptor (70) of claim 7 characterized in that the semiconductor alloy material includes fluorine as the halogen or pseudo-halogen.

11. The photoreceptor (70) of claim 7 characterized in that the boron is substantially tetrahedrally incorporated into the semiconductor host matrix.

12. The photoreceptor (70) of claim 7 characterized in that the photoconductive member (78) is formed of an amorphous silicon:hydrogen:fluorine alloy including a sufficient amount of boron to provide an activation energy in the range of 0.8 to 1.2 electron volts.

13. The photoreceptor (70) of claim 12 including a blocking layer (76) interposed between the photoconductive member (78) and the substrate, characterized in that said blocking layer (76) is formed of a semiconductor alloy material having a conductivity type inhibiting injection of charge carriers from the substrate (72) into the photoconductive member (78).

14. The photoreceptor (70) of claim 13 characterized in that the blocking layer (76) is formed of an amorphous silicon:hydrogen:fluorine alloys, said blocking layer (76) including a greater amount of boron than the photoconductive member (78).

15. The photoreceptor (70) of claim 13 characterized in that an adhesion-promoting layer (74) is interposed between the substrate (72) and the blocking layer (76); and an insulating layer (80) is disposed on the photoconductive member.

16. The improved electrophotographic photoreceptor (70) of claim 7 characterized in that said photoconductive member (78) is formed of a plurality of superposed layers of semiconductor alloy material

differing in the concentration of at least one element, whereby bulk stress within the photoconductive member (78) is relieved so as to improve the charge storage capability of the photoreceptor (70).

17. The electrophotographic photoreceptor (70) of claim 16 wherein said superposed layers of semiconductor material are formed from a silicon:hydrogen:fluorine alloy, characterized in that said superposed layers differ in the amount of fluorine incorporated in them.

18. The electrophotographic photoreceptor (70) of claim 17 wherein the photoconductive member (78) is approximately 15 to 30 microns thick and displays a columnar growth morphology, said photoreceptor further including:

a blocking semiconductor layer (76) interposed between the photoconductive member (78) and the substrate (72), said semiconductor layer (76) being approximately 200 to 600 nanometers thick, said blocking layer (76) preventing the injection of charge carriers from the substrate (72) into the photoconductive layer (78);

an adhesion-promoting layer (74) of approximately 50 to 200 nanometers thickness interposed between the blocking layer (76) and the substrate (72); and

an electrically insulating layer (80) of less than 600 nanometer thickness disposed on the photoconductive member (78), characterized in that said semiconductor layer (76) includes therein boron in an amount greater than in the photoconductive member (78).

19. A glow discharge deposition method for the production of an improved electrophotographic photoreceptor including a photoconductive member, the method including the steps of:

disposing an electrically conductive substrate member in a glow discharge deposition apparatus;

supplying to said apparatus a photoconductive member precursor gas mixture including substantially mono-atomic boron and a halogen or pseudo-halogen, and a semiconductor host matrix forming material; and

energizing said precursor gas mixture with electromagnetic energy to deposit a semiconductor host matrix characterized in that said matrix contains boron and a halogen or pseudo-halogen substantially mono-atomically incorporated therein, whereby a photoconductive member exhibiting substantially reduced bulk stress is prepared.

20. The method of claim 19 characterized in that the step of energizing said precursor gas mixture comprises energizing said precursor gas with electromagnetic energy at a frequency of one of approximately 13.56 MHz and 2.54 GHz.

21. The method of claim 19 characterized in that the step of providing a precursor gas comprises providing precursor gasses including at least one of silicon, germanium and mixtures of silicon and germanium.

22. The method of claim 19 characterized in that the step of providing a precursor gas comprises providing a precursor gas including fluorine.

23. The method of claim 19 characterized in changing the composition of the precursor gas mixture from a first composition to a second composition after a first portion of the photoconductive member is deposited, and depositing a second portion of the photoconductive member from said second composition of said precursor gas mixture.

24. The method of claim 23 characterized in that the step of changing the composition of the precursor gas mixture comprises changing the relative amount of fluorine in the precursor gas mixture.

25. The method of claim 22 characterized in:

changing the composition of the precursor gas mixture after the second portion of the photoconductive member is deposited to a third composition; and

depositing a third portion of the photoconductive member from said third composition of said precursor gas mixture.

26. The method of claim 19 characterized in that the step of providing a photoconductive member precursor gas mixture comprises providing a precursor gas including silane, hydrogen, silicon tetrafluoride and boron trifluoride.

27. The method of claim 19 characterized in that depositing a doped semiconductor layer between the substrate and the photoconductive member.

28. The method of claim 27 characterized in that the step of depositing a doped semiconductor layer comprises: depositing said doped layer by establishing a glow discharge in gaseous mixture including silane, silicon tetrafluoride, hydrogen and boron trifluoride.

29. The method of claim 19 characterized in depositing an adhesion-promoting layer on the substrate member.

30. The method of claim 29 characterized in that the step of depositing an adhesion-promoting layer comprises depositing a layer of a material chosen from the group consisting essentially of silicon nitride, silicon carbide, silicon oxide, and combinations thereof.

31. The method of claim 19 characterized in depositing a layer of an electrically insulating material on the photoconductive member.

0181113

1/4

FIG. 1

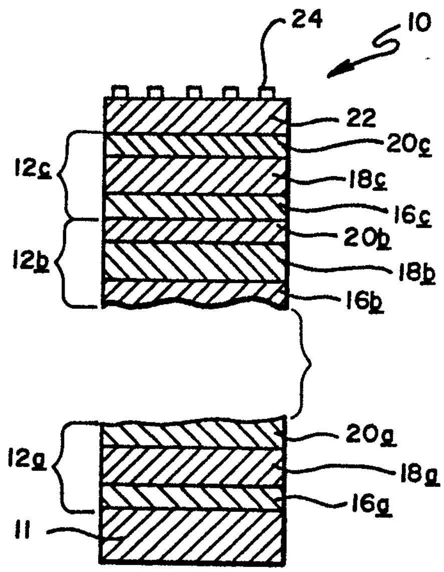


FIG. 2

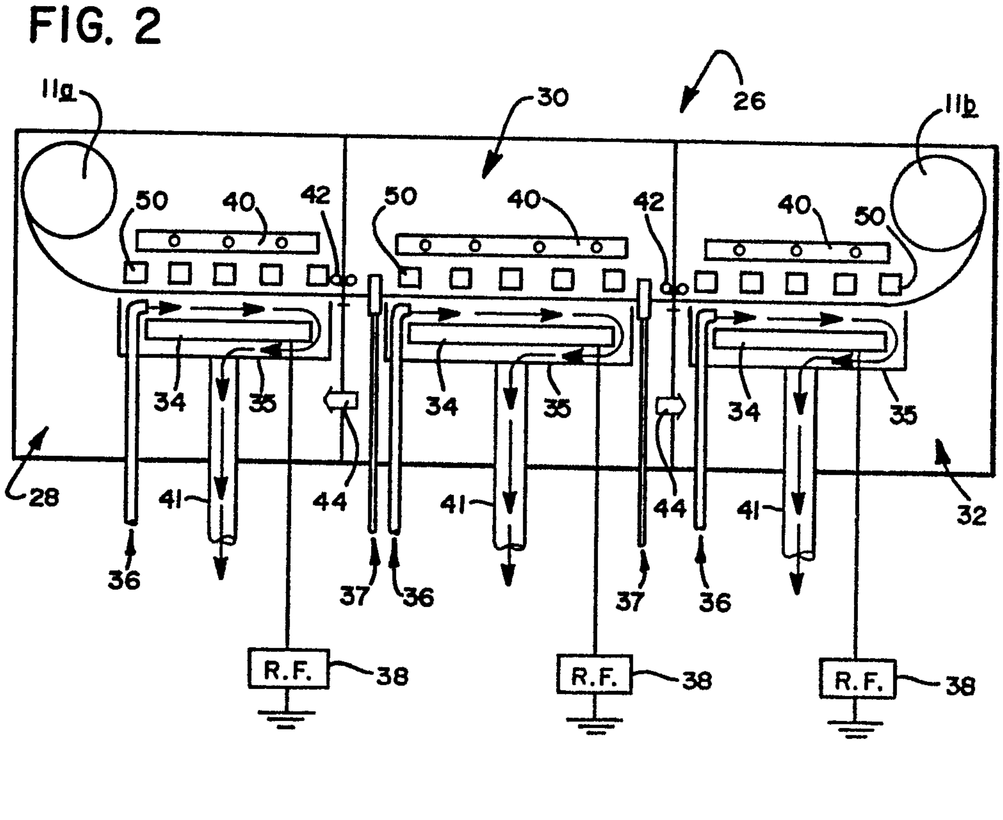

FIG. 3A

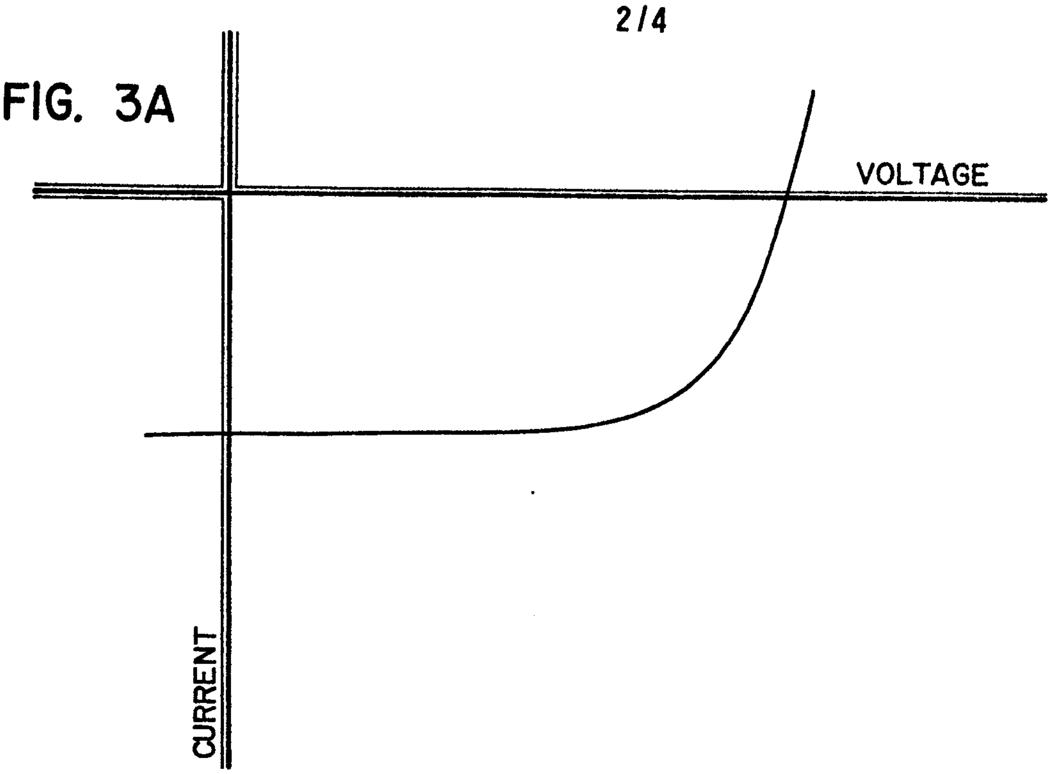


FIG. 3B

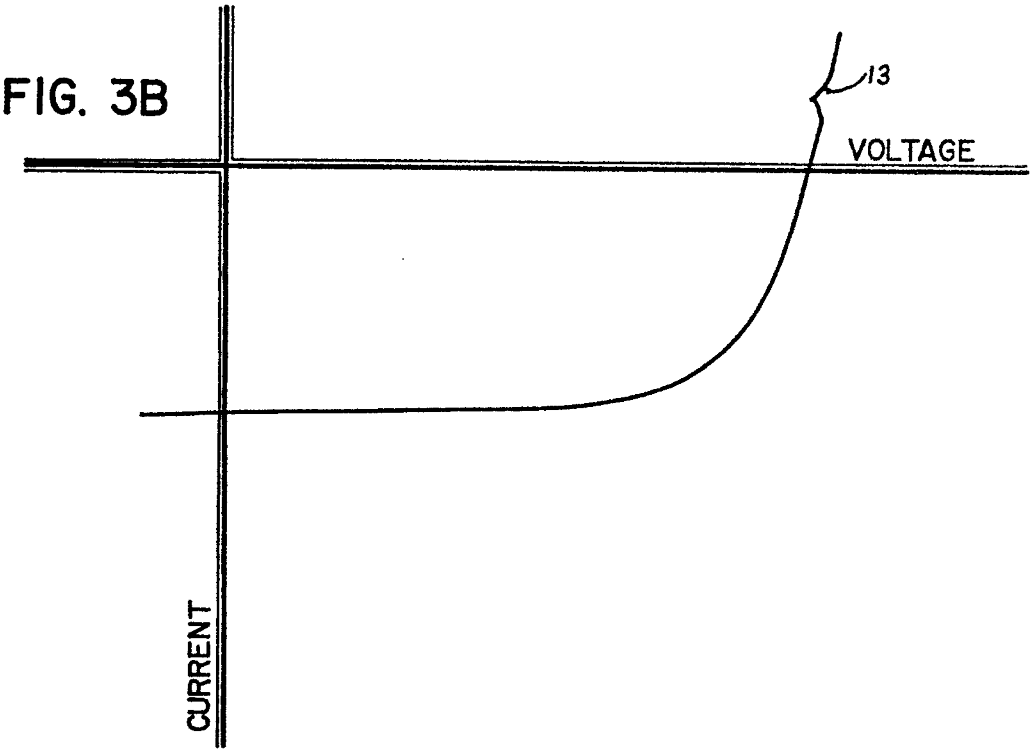

FIG. 4

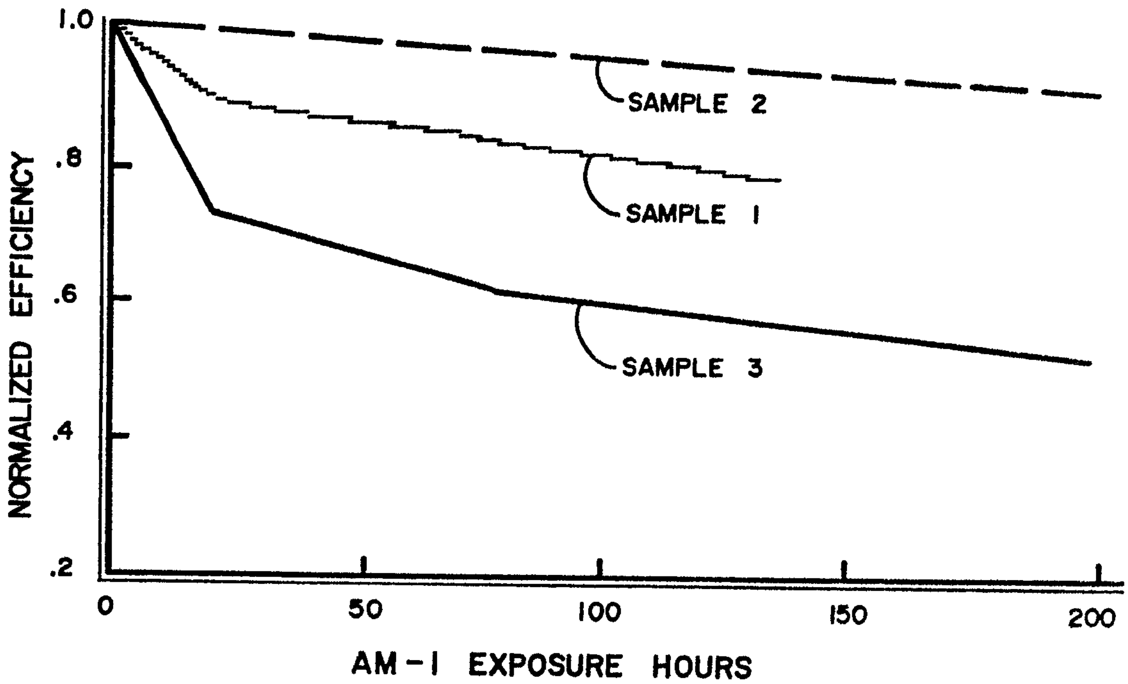
1.0
.8
.6
.4
.2
NORMALIZED EFFICIENCY
SAMPLE 2
SAMPLE 1
SAMPLE 3
0
50
100
150
200
AM-I EXPOSURE HOURS

FIG. 5

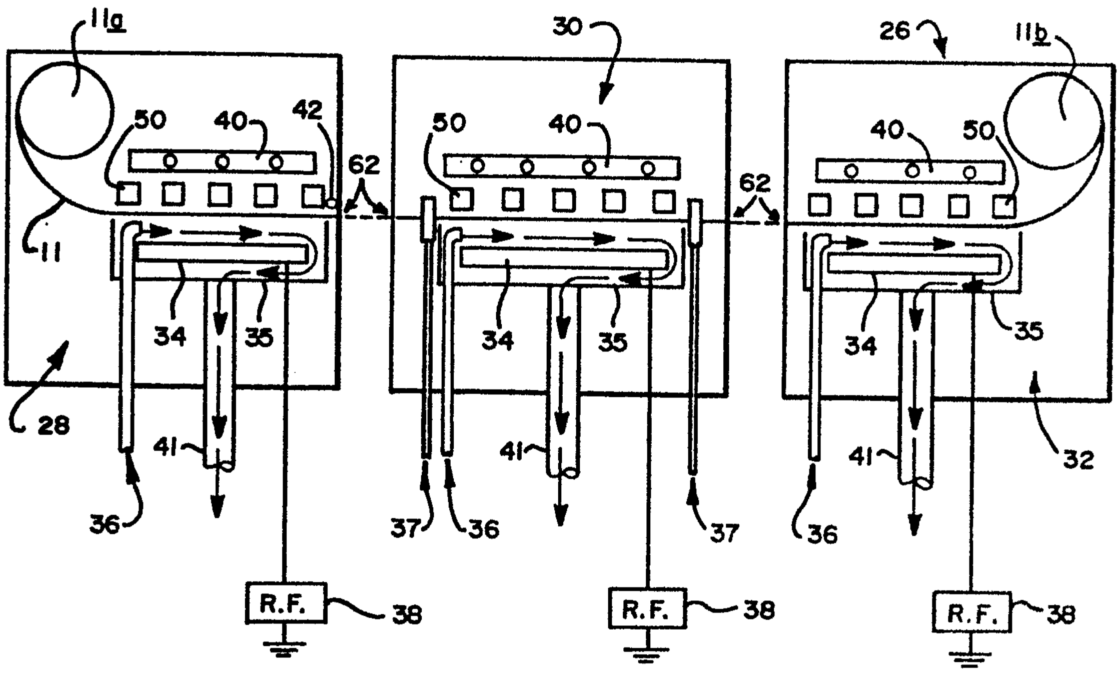
11a
50
40
42
62
11
28
34
35
36
41
R.F.
38
30
37
26
11b
32

FIG. 6

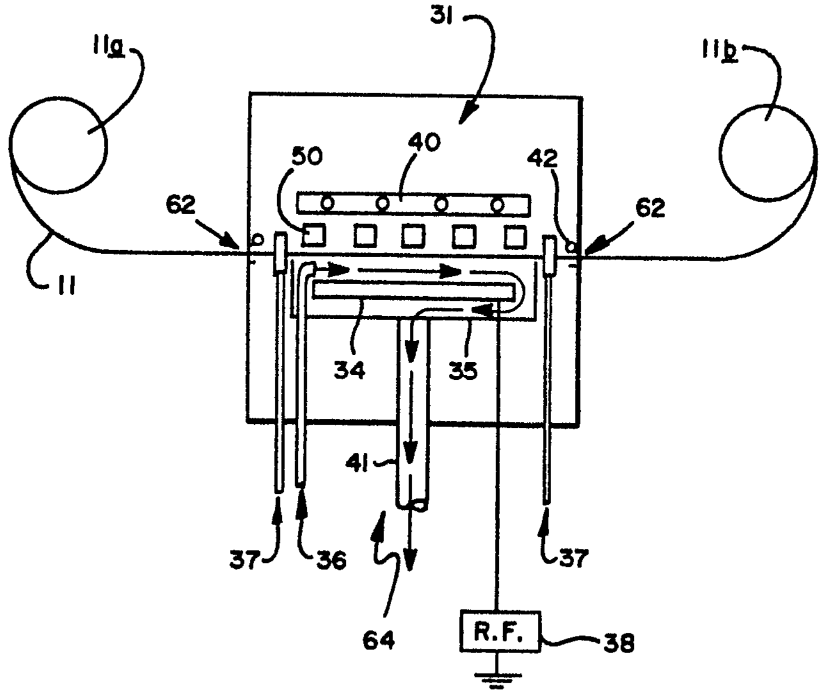
31
11a
11b
50
40
42
62
62
11
34
35
41
37
36
37
64
R.F.
38

FIG. 7

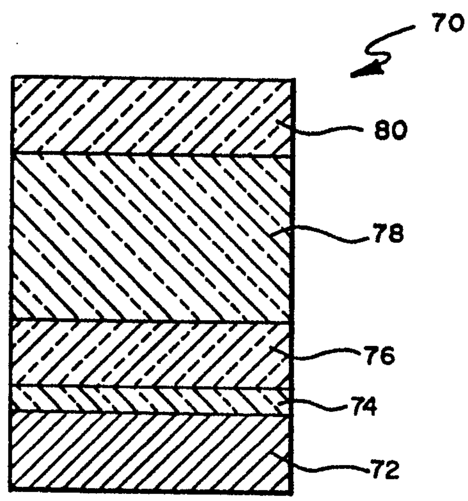
70
80
78
76
74
72